# EUROPEAN PATENT SPECIFICATION

(11) **EP 2 104 151 B1**
(45) Date of publication and mention of the grant of the patent: **17.07.2013**
(21) Application number: 07858288.9
(22) Date of filing: 05.12.2007
(51) Int. Cl.: H01L 39/24, C01G 3/00, C01G 19/00, C01G 25/00, C01G 45/00, H01L 39/12

(54) **NANOSTRUCTURED SUPERCONDUCTING MATERIAL OF TYPE REBA2CU3O7 (RE=RARE EARTH OR YTTRIUM) WITH A HIGH DENSITY OF VORTEX ANCHORING CENTRES AND PREPARATION METHOD THEREOF**
NANOSTRUKTURIERTES SUPRALEITENDES MATERIAL DES TYPS REBA2CU307 (RE=SELTENERD ODER YTTRIUM) MIT HOHER DICHTE VON VORTEX-ANCHORING-ZENTREN UND HERSTELLUNGSVERFAHREN DAFÜR
MATÉRIAU SUPRACONDUCTEUR NANOSTRUCTURÉ DE TYPE REBa2Cu3O7 (RE = TERRE RARE OU YTTRIUM) PRÉSENTANT UNE DENSITÉ ÉLEVÉE DE CENTRES D'ANCRAGE DE VORTEX, ET PROCÉDÉ DE PRÉPARATION CORRESPONDANT

(30) Priority: 14.12.2006 ES 200603172
(43) Date of publication of application: 23.09.2009
(73) Proprietor: CONSEJO SUPERIOR DE INVESTIGACIONES CIENTIFICAS, 28006 Madrid (ES)
(72) Inventor: OBRADORS BERENGUER, Xavier, 08193 Bellaterra (ES); PUIG MOLINA, Teresa, 08193 Bellaterra (ES); RICART MIRÓ, Susana, 08193 Bellaterra (ES); POMAR BARBEITO, Alberto, 08193 Bellaterra (ES); SANDIUMENGE ORTIZ, Felip, 08193 Bellaterra (ES); MESTRES ANDREU, Narcis, 08193 Bellaterra (ES); LLORDÉS GIL, Anna, 08193 Bellaterra (ES); GIBERT GUTIÉRREZ, Marta, 08193 Bellaterra (ES); GUTIERREZ ROYO, Jofre, 08193 Bellaterra (ES); GÁZQUEZ ALABART, Jaume, 08193 Bellaterra (ES); ROMA BUYREU, Neus, 08193 Bellaterra (ES)
(74) Representative: Pons Ariño, Angel
(86) International application number: PCT/ES2007/070204
(87) International publication number: WO 2008/071829

(56) References cited:
- WO-A2-2005/081710
- WO-A2-2005/081710
- OBRADORS X ET AL: "Progress towards all-chemical superconducting YBa2Cu3O7-coated conductors", SUPERCONDUCTOR SCIENCE AND TECHNOLOGY, IOP PUBLISHING, TECHNO HOUSE, BRISTOL, GB, vol. 19, no. 3, 1 March 2006 (2006-03-01), pages S13-S26, XP020100846, ISSN: 0953-2048, DOI: 10.1088/0953-2048/19/3/003
- GUTIERREZ J ET AL: "Strong isotropic flux pinning in solution-derived YBA2Cu2O7_X nanocomposite superconductor films", NATURE MATERIALS, NATURE PUBLISHING GROUP, LONDON, GB, vol. 6, no. 5, 22 April 2007 (2007-04-22), pages 367-373, XP008110110, ISSN: 1476-4660, DOI: 10.1038/NMAT1893
- GUTIERREZ J. ET AL.: 'Strong isotropic flux pinning in solution-derived YBA2Cu2O7_X nanocomposite superconductor films' NATURE MATERIALS vol. 6, 22 April 2007, pages 367 - 373, XP008110110
- OBRADORS X. ET AL.: 'Progress towards all-chemical superconducting YBa2CuO7-coated conductors' SCIENCE AND TECHNOLOGY vol. 19, 20 January 2006, pages S13 - S26, XP020100846

## Description

### FIELD OF THE INVENTION

The present invention refers to films of superconductor material with a high density of nanometric defects in its structure, suitable for effectively anchoring vortices almost isotropically vortices and the processes for effectively developing this structure of defects. The objects of the present invention are of special relevance to the following sectors:
- Chemical sector: Chemical precursors of soluble metal-organic compounds.
- Ceramics-metallurgy sector: Deposition and growth of nanocomposite ceramic coverings on metal or ceramic substrates. Generation of functional nanostructures on ceramic or metallic substrates.
- Energy sector, Electromechanics and Transport: Improvement in the efficiency of existing electrical equipment for generation, transport, distribution and use of electrical power, development of new power electrical equipment, powerful electromagnets for various applications (including nuclear fusion), powerful and light electrical motors for the aeronautical and nautical industries.
- Biomedicine and Pharmaceutical sector: New magnetic resonance diagnostic equipment, more powerful and able to operate at higher temperature and new magnetic resonance spectrometers for molecular design.
- Electronics sector: New devices, passive or active, that work in the microwave range and that are of interest in the Telecommunications field.

### STATE OF THE ART

High temperature superconducting materials have enormous potential for use in a wide variety of technologies but an indispensable requirement is the development of methods for obtaining conductors with high performance, in particular with the ability to transport high electrical currents without loss, even under high magnetic fields. The first high temperature superconductors that were developed were based on phases of the type BiSrCaCuO and these are called superconductors of the first generation (1G). The development of these materials was profoundly revolutionised with the discovery of a new method of preparation of a second generation (2G) of superconductors based on materials of the type REBa₂Cu₃O₇ (where RE = rare earth or yttrium), called expitaxial superconducting coated conductors.

Telecommunications technologies working in the microwave range require the use of thin superconducting films due to their low surface resistance, which confers better performance on devices based on such materials. In particular, the need to improve the critical currents of superconducting films in order to reduce the non-linear effects at high power is worth mentioning. For these applications, the substrates required are monocrystalline with low loss in the microwave range.

Over the last few years, various methods have been developed for obtaining expitaxial superconducting coated conductors based on a variety of multi-layer architectures with high potential for high-field, high-temperature and high-current applications. Various strategies have been followed for the preparation of these 2G conductors, based mainly on methodologies of deposition in vacuum of expitaxial layers on metal substrates. These substrates can either have a cap film with textured oxide deposited by Ion Beam Assisted Deposition (IBAD) on a polycrystalline substrate or can be composed of textured cap layers replicating the texture achieved on substrates via Rolling-Assisted Biaxial-Texturing (RABiTs) obtained by thermo-mechanical processes. Other interesting approaches are also those where the textured cap layer is achieved by Surface Oxidation Epitaxy (SOE) or by Inclined Surface Deposition (ISD).

Once these structured substrates have been obtained, deposition of epitaxial oxides is carried out in the form of a multi-layer that acts as a cap to atomic diffusion and oxidation and of the superconducting layer REBa₂Cu₃O₇, which carries the electric current. To prepare these multi-layer structures, techniques of deposition in vacuum (evaporation, ablation, laser sputtering) or techniques of deposition based on metal-organic chemical solutions (chemical solution deposition, CSD) can be used. These latter are particularly interesting due to the possibilities of developing low cost expitaxial superconducting coated conductors. The most promising metal-organic precursors for the CSD technique for the growth of superconducting films are the trifluoroacetates.

The demonstration of the possibility of using trifluoroacetate (TFA) precursors to grow the REBa₂Cu₃O₇ superconductor has been broadly described as a very important step forward (A. Gupta, R. Jagannathan, E.I. Cooper, E.A. Giess, J.I. Landman, B.W. Hussey, "Superconducting oxide films with high transition temperature prepared from metal trifluoroacetate precursors", Appl. Phys. Lett. 52, 1988, 2077; P.C. Mclntyre, M.J. Cima and M.F. Ng, "Metalorganic deposition of high-J Ba2YCu3O7 thin films from trifluoroacetate precursors onto (100) SrTiO3", J. Appl. Phys., 68, 1990, 4183). These precursors have BaF₂, Y₂O₃ and CuO as final products after the decomposition of the metal-organic precursors and therefore prevent the formation of BaCO₃, which enables growing thin films of YBCO a lower temperatures. Recently, a new method has been described for obtaining anhydride precursors of TFA that enable obtaining films of high quality at the same time as reducing the time required for the processing of the films and increasing the stability of the precursors solution (X. Obradors, T. Puig, S. Ricart, N. Romà, J.M. Moretó, A. Pomar, K. Zalamova, J. Gázquez and F. Sandiumenge, "Preparación de precursores metalorgánicos anhidros y uso para la deposición y crecimiento de capas y cintas superconductoras", 2005, Patent 200500749, Spain; N. Roma, S. Morlens, S. Ricart, K. Zalamova, J.M. Moretó, A. Pomar, T. Puig and X. Obradors, "Acid anhydrides: a simple route to highly pure organometallic solutions for superconducting films", Supercond. Sci. Technol., 2006, 19, 521). These precursors have been widely used to obtain films and multi-layers of high crystalline quality and good superconducting properties (X. Obradors, T. Puig, A. Pomar, F. Sandiumenge, N. Mestres, M. Coll, A. Cavallaro, Roma, J. Gázquez, J.C. Gonzalez, O. Castaño, J. Gutierrez, A. Palau, K. Zalamova, S. Morlens, A. Hassini, M. Gibert, S. Ricart, J.M. Moretó, S. Piñol, D. Isfort, J. Bock., "Progress towards all chemical superconducting YBCO coated conductors", Supercond. Sci. Technol., 2006, 19, S13).

However, the most important advance currently required in the field of expitaxial superconducting coated conductors is the development of radically innovative methods for the generation of embedded nanostructures in expitaxial films of YBCO. The scientific motive for constructing this new class of nanocomposite expitaxial superconducting coated conductors lies in the need to develop efficient vortex anchoring centres. The capacity of superconducting materials to support high currents in magnetic fields without loss is controlled by their ability to trap vortices in non-superconducting defects. The critical current density J_{c} is reached when the vortices are freed and cease to be immobilised by nanometric defects. If efficient anchoring of the vortices is achieved, it will be possible to develop electrotechnical systems at high temperatures (60-77 K) and high magnetic fields (1-5 Tesla). Ideal anchoring centres must have a diameter of 10-50 nm and a high density to maximise the volume of the nucleus of the anchored vortex. It is not, however, necessary to achieve long range order of the defects.

The emergence of bottom-up strategies in nanotechnology has revolutionised this discipline due to its great potential as a low cost method that can be easily translated to the large-scale production of advanced nanostructured materials. This strategy enables the implementation of radically new ideas for the development of nanocomposite or nanostructured materials exhibiting new or improved functionalities. To date, superconductor nanostructuralisation has only been achieved using lithography techniques in classical vacuum. These nanostructured materials show very attractive physical properties such as the vortex anchoring phenomena. However, these nanostructuralisation techniques are limited to small areas due to their high cost.

Synthesis methods based on metal-organic chemical solutions have demonstrated their potential as low cost techniques for manufacturing thin and multi-layer films of functional oxides and superconducting tapes with good properties but have still not been practically used for obtaining nanocomposite systems.

Recently, techniques of thin film deposition based on vacuum techniques (ablation, laser sputtering, evaporation, etc.) have demonstrated that they can be used to obtain superconducting nano-composites with non-superconducting secondary phases (J.L. Macmanus-Driscoll, S.R. Foltyn, Q.X. Jia, H. Wang, A. Serquis, L. Civale, B. Maiorov, M.P. Maley, and D. E. Peterson, "Strongly enhanced current densities in superconducting coated conductors of YBa2Cu3O7-x + BaZrO3", Nature Mat. 2004, 3, 439; A. Goyal, S. Kang, K.J. Leonard, P.M. Martin, A.A. Gapud, M. Varela, M. Paranthaman, A.O. Ijaduola, E.D. Specht, J.R. Thompson, D.K. Christen, S.J. Pennycook and F.A. List, "Irradiation-free, columnar defects comprised of self- assembled nanodots and nanorods resulting in strongly enhanced flux-pinning in YBa2Cu3O7-x films", Supercond. Sci. Technol. 2005, 18, 1533; Y. Yamada, K. Takahashi, H. Kobayashi, M. Konishi, T. Watanabe, A. Ibi, T. Muroga and S. Miyata T. Kato, T. Hirayama, Y. Shiohara, "Epitaxial nanostructure and defects effective for pinning in (Y,RE)Ba2Cu3O7-x coated conductors", Applied Physics Letters. 2005, 87, 132502). The second crystalline phase is segregated in textured nano-particulate form and can be distributed at random or form nanorods that perpendicularly cross the film. These nanostructures have shown some success in the improvement of the superconducting properties, particularly the critical current, depending both on their dimensions in the nanometric scale and if they are able to generate defects in the YBCO superconducting matrix. The improvement is principally caused when the magnetic field is orientated along the columnar defects created. Nevertheless, although these experiments have suggested a promising route for obtaining new conductors with improved properties, they have still been unable to introduce significant changes (M.W. Rupich, T. Kodenkandath, N. Grafton, W. Zhang, X. Li, "Oxide films with nanodot flux pinning centres", US Patent 2005/0159298 A1).

### DESCRIPTION OF THE INVENTION

### Short Description

An object of the present invention is a nanostructured superconducting material of type REBa₂Cu₃O₇, where RE = rare earth or yttrium, henceforth called the superconducting material of the invention, characterised by a structure comprising:
- two phases:
   ○ a main matrix of REBa₂Cu₃O₇,
   ○ a secondary phase of BaZrO₃ distributed at random throughout the matrix
and with a density of nanometric defects in its structure in the range of 10³-10⁴ defects/µm³, A particular object of the invention is a system composed of the superconducting material of the invention and a substrate on which the superconducting material is deposited.

A particular embodiment of the invention is a system composed of the superconducting material of the invention and a substrate of rigid films of monocrystalline substrate.

Another particular embodiment of the invention is a system composed of the superconducting material of the invention and a substrate of flexible metallic tapes.

Another object of the invention is the procedure for obtaining thin layers of nanostructured superconducting oxides of the type REBa₂Cu₃O₇ that comprises the stages of:
a) preparation of a precursor trifluoroacetate solution with various salts of Zr,
b) deposition of the solution on a substrate by means of any method enabling the homogenous control of the thickness of the film,
c) decomposition of the metal-organic precursors by means of thermal treatment in a controlled atmosphere,
d) thermal treatment at high temperature in a controlled atmosphere for crystallisation of the superconducting layer,
hereafter call the procedure for obtaining superconductors of the invention, in which the precursor solution of stage a) contains variable proportions of salts of alkaline metals, alkaline earth metals, rare earth metals and/or transition metals.

Another particular object of the invention is the procedure for obtaining superconductors of the invention in which the salts of alkaline metals, alkaline earth metals, rare earth metals and/or transition metals used in stage a) are organic salts such as acetates, trifluoroacetates, acetylacetonates, ethylhexanoates or propionates that are soluble in the reaction medium to prevent the formation of precipitates.

Another particular object of the invention is the procedure for obtaining the superconductors of the invention in which complex anhydride solutions of RE, Ba and Cu trifluoroacetates with various salts of Zr are obtained in stage a).

Another particular object of the invention is the procedure for obtaining superconductors of the invention in which any anhydride of another organic acid that dissolves oxide powders is used in stage a).

A particular embodiment of the invention in the procedure for obtaining superconductors of the invention in which trifluoroacetic anhydride (CF₃CO)₂O) and a small quantity of trifluoroacetic acid (CF₃COOH) (5% by volume) as a catalyst of the reaction are used in stage a).

Another particular object of the present invention is the procedure for obtaining superconductors of the invention in which in stage a) solutions of metal trifluoroacetates are used including variable proportions of nanoparticles of metal oxides (BaZrO₃) in which these nanoparticles have been prepared by means of oxidation-reduction reactions, precipitation and stabilisation with surfactants, polymers or organic species able to link to their surface thereby preventing their aggregation.

Another particular object of the present invention is the procedure for obtaining superconductors of the invention in which the substrate used in stage b) has previously been covered with a layer of BaZrO₃ nanoparticles of metal oxides by means of auto-assembly processes based on growth from metal-organic solutions or by the deposition of previously synthesised nanoparticles.

Another object of the invention is the use of the superconducting material of the invention in electronic devices.

Another object of the invention is the use of the superconducting material of the invention in electric systems, improving existing systems for the generation, transport and distribution of the use of electric power.

### Detailed description

The properties of superconducting materials at high temperatures and low magnetic fields are determined by their ability to effectively anchor vortices (magnetic flux quanta) existing in these materials and this process is optimum when there is a dense and homogenous distribution of non-superconducting defects with nanometric dimensions. Crystalline defects that can give rise to this beneficial effect of anchoring vortices can be of very diverse nature, including nanoparticles of secondary phases, dislocations, stacking faults, intergrowth of non-superconducting phases, grain boundaries and residual tensions caused by all of these.

The critical current density in superconducting materials is normally anisotropic due to their crystallographic structure, that is it depends on the orientation of the magnetic field H with respect to the crystallographic axes of the superconducting material. For the majority of electrotechnical applications, it is desirable to minimise this anisotropy and therefore the development of methods for manufacturing materials, such as those described in the present invention that reduce this anisotropy, are of great practical interest.

The present invention refers to film of superconductor material with a high density of nanometric defects in its structure, suitable for effectively anchoring vortices almost isotropically and the processes for effectively developing this structure of defects.

An object of the present invention is a nanostructured superconducting material of type REBa₂Cu₃O₇, where RE = rare earth or yttrium, henceforth called the superconducting material of the invention, characterised by a structure comprising:
- two phases:
   ○ a main matrix of REBa₂Cu₃O₇,
   ○ a secondary phase of BaZrO₃ distributed at random throughout the matrix,
and with a density of nanometric defects in its structure in the range of 10³-10⁴ defects/µm³. Nanometric defects are understood to be nanoparticles, dislocations, partial dislocations surrounding stacking faults, stacking faults or grain boundaries. The fact that the average separation between nanometric defects of these materials may only be a few tens of nm allows the superconducting vortices to be anchored continuously along the whole length of these defects. The high density of defects is what confers increased efficiency to the process of vortex anchoring when high magnetic fields are applied, in which their density is also raised.

The critical current anisotropy values depend above all on the magnetic field and more weakly on the temperature. The superconducting material of the invention in a magnetic field of 1 T, when the orientation of the magnetic field is changed, shows changes in critical current with a quotient between the maximum and minimum of 1.5-1.8, which is a 100% reduction compared to that shown by thin REBa₂Cu₃O₇ films without secondary phases.

A particular object of the invention is a system composed of the superconducting material of the invention and a substrate on which the superconducting material is deposited.

A particular embodiment of the invention is the superconducting material of the invention deposited on rigid films of monocrystalline substrate.

Another particular embodiment of the invention is the superconducting material of the invention deposited on flexible metallic tapes.

Another object of the invention is the procedure for obtaining thin layers of nanostructured superconducting oxides of the type REBa₂Cu₃O₇ comprising the stages of:
a) preparation of a precursor trifluoroacetate solution with various salts of Zr,
b) deposition of the solution on a substrate by means of any method enabling the homogenous control of the thickness of the film,
c) decomposition of the metal-organic precursors by means of thermal treatment in a controlled atmosphere,
d) thermal treatment at high temperature in a controlled atmosphere to crystallise the superconducting layer,
hereafter called the procedure for obtaining superconductors of the invention, in which the precursor solution of stage a) contains variable proportions of salts of alkaline metals, alkaline earth metals, rare earth metals and/or transition metals.

The fundamental difference between this method compared to the method described in the patent request PCT/ ES2005/070056 is in the use of salts of alkaline metals, alkaline earth metals, rare earth metals and/or transition metals in the precursor. These salts lead to the formation of a secondary phase of BaZrO₃, within the main REBa₂Cu₃O₇ matrix providing a high density of nanometric defects in the structure of the material, increasing the capacity of effectively anchoring the vortices.

Another particular object of the invention is the procedure for obtaining superconductors of the invention in which the salts of alkaline metals, alkaline earth metals, rare earth metals and/or transition metals used in stage a) are organic salts such as acetates, trifluoroacetates, acetylacetonates, ethylhexanoates or propionates that are soluble in the reaction medium to prevent the formation of precipitates.

Another particular object of the invention is the procedure for obtaining the superconductors of the invention in which complex anhydride solutions of RE, Ba and Cu trifluoroacetates are obtained in stage a).

Another particular object of the invention is the procedure for obtaining superconductors of the invention in which any anhydride of another organic acid that dissolves oxide powders is used in stage a).

A particular embodiment of the invention in the procedure for obtaining superconductors of the invention in which trifluoroacetic anhydride (CF₃CO)₂O) and a small quantity of trifluoroacetic acid (CF₃COOH) (5% by volume) as a catalyst of the reaction are used in stage a).

The choice of the maximum temperature for the thermal treatment of stage c) is determined by the substrate used as well as the secondary minor phase that is desired in the material. These conditions of thermal treatment will also be determining for the generation of a suitable defect structure in the superconductor.

Another particular object of the present invention is the procedure for obtaining superconductors of the invention in which in stage a) solutions of metal trifluoroacetates are used with variable proportions of nanoparticles of metal oxides (BaZrO₃) in which these nanoparticles have been prepared by means of oxidation-reduction reactions, precipitation and stabilisation using surfactants, polymers or organic species able to link to their surface thereby preventing their aggregation (oleic acid and its derivatives, dodecylamine, PVP, PEG, long chain thiols). These particles will be prepared in the form of a solution of known concentration compatible with the solvent used in the metal trifluoroacetate solutions.

Another particular object of the present invention is the procedure for obtaining superconductors of the invention in which the substrate used in stage b) has previously been covered with a layer of BaZrO₃ nanoparticles of metal oxides by means of auto-assembly processes based on growth from metal-organic solutions or in the deposition of previously synthesised nanoparticles. These nanoparticles will be used as templates and on them will be deposited and decomposed the metal trifluoroacetate solutions prepared in anhydrous or partially hydrolysed conditions and the purpose of their introduction is for them to act as defect nucleating centres in the superconducting layers deposited on them.

The process of formation of the nano-templates of oxides or metals follows similar stages to those previously described (deposition, pyrolysis and growth) but the concentrations of the metal-organic solutions of the oxides that are desired are less (0.003 to 0.02 M) so that they only partially cover the substrate. The duration of the thermal treatment and the atmosphere and temperature in which it takes place will determine the size and morphology of the nanoparticles that are obtained. Also a determining parameter of the difference of the crystalline network parameters is that between the oxide growing in the form of nanoparticles and the corresponding substrate. This approximation to the formation of nanoparticles will lead to epitaxial structures with a well determined crystalline orientation. By contrast, previously synthesised nanoparticles will be randomly orientated.

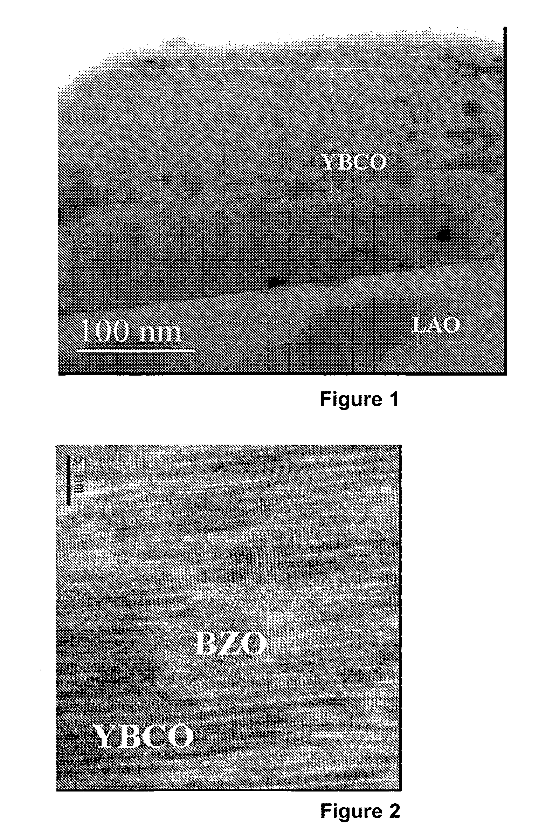

In all the objects of the invention previously described, the aspect that confers a practical utility to the superconductors emanates from the fact of having created, by means of an appropriate selection of composition and process, a dense defect structure in the REBa₂Cu₃O₇ matrix that effectively anchors the vortices. In figure 1 and figure 2, the transmission electron microscopy images show that the crystalline REBa₂Cu₃O₇ network was strongly disordered when BaZrO₃ nanoparticles were introduced. Particularly, the nanoparticles themselves and various types of deformations of the network are identified such as intergrowths and dislocations, which lead to an intense disruption of the crystallographic planes. The success with which these disordered structures are generated is what determines the improvement in properties of the superconducting material under intense magnetic fields.

The reason explaining the extraordinary improvement in the superconducting properties lies in the formation of a high concentration of defects (10³-10⁴ defects/µm³) in the REBa₂Cu₃O₇ matrix. This is due to secondary nanoparticles being orientated at random, without any crystallographic relationship to the matrix and therefore the interface has a high energy that acts as a driving force for the generation of defects. The reason that the secondary phases are distributed at random is that their formation is prior to the crystallisation of REBa₂Cu₃O₇ and, in consequence, all those that are localised outside the interface with the substrate do not have any reason to orientate according to the specific crystallographic orientation. This characteristic distinguishes the materials obtained here from those previously prepared by vacuum deposition techniques in which both phases crystallise simultaneously.

Therefore it is particularly important to control the size of the secondary nanoparticles, which results in a control of the concentration of generated defects. Also, the formation of an excess volume of non-superconducting phase must be avoided (for example with precipitates or pores of micrometer size or greater) as these will lead to a harmful effect of blocking the circulation of the current and therefore a reduction of its electrical properties. For this reason, maintaining the nanometric size of the defects created is of great importance.

Finally, an added advantage of the objects of the invention described is that they have reduced anisotropy of the critical currents. This is due to the fact that the generated defects have an isotropic character and that the angular distribution of the structure in terms of the layer mosaic is increased. This reduction of anisotropy allows greater flexibility in the design of superconducting coils based on tapes that are manufactured following the new procedure described in the present invention.

Another object of the invention is the use of the superconducting material of the invention in electronic devices.

Another object of the invention is the use of the superconducting material of the invention in electric systems, improving existing systems for the generation, transport and distribution of the use of electric power. angular distribution of the structure in terms of the layer mosaic is increased. This reduction of anisotropy allows greater flexibility in the design of superconducting coils based on tapes that are manufactured following the new procedure described in the present invention.

Another object of the invention is the use of the superconducting material of the invention in electronic devices.

Another object of the invention is the use of the superconducting material of the invention in electric systems, improving existing systems for the generation, transport and distribution of the use of electric power.

### Description of the figures:

Figure 1. Transverse image by transmission electron microscopy of a layer of YBa₂Cu₃O₇ with 5% by weight of BaZrO₃ nanoparticles.
Figure 2. Transmission electron microscopy image of a layer of YBa₂Cu₃O₇ with BaZr03 nanoparticles in which a large concentration of generated defects can be observed in the YBa₂Cu₃O₇ matrix.
Figure 3. Critical current at 65 K as a function of the magnetic field applied perpendicularly to the substrate of a reference layer of YBa₂Cu₃O₇ and a layer of YBa₂Cu₃O₇ with 10% molar BaZrO₃ nanoparticles.
Figure 4. Critical current at 77 K as a function of the magnetic field applied perpendicularly to the substrate of a reference layer of YBa₂Cu₃O₇ and a layer of YBa₂Cu₃O₇ with 10% molar BaZrO₃ nanoparticles.
Figure 5. Pinning force at 77 K, Fₚ=J_{c}B as a function of the magnetic field applied perpendicularly to the substrate of a layer of standard TFA-YBCA and a layer of TFA-YBCO with BZO nanoparticles. By comparison, the dependence of the pinning force of a conventional superconducting wire of NbTi at 4.2 K is shown.
Figure 6. Optical microscopy image of a layer of YBa₂Cu₃O₇ with 5% by weight of BaZrO₃ nanoparticles after the process of pyrolysis.
Figure 7. X-ray diffraction spectrum θ-2θ of a layer of YBa₂Cu₃O₇ with 5% by weight of BaZrO₃ nanoparticles.
Figure 8. Angular dependence of the critical current density at 77 K as a function of the angle formed between the applied magnetic field and the substrate for a layer of standard TFA-YBCO and a layer of TFA-YBCO with BZO nanoparticles.
Figure 9. Optical microscopy image of a layer of YBa₂Cu₃O₇ with 5% by weight of Y₂O₃ nanoparticles after the process of pyrolysis.
Figure 10. X-ray diffraction spectrum θ-2θ of a layer of YBa₂Cu₃O₇ with 5% by weight of Y₂O₃ nanoparticles.
Figure 11. Optical microscopy image of a layer of YBa₂Cu₃O₇ with 5% by weight of Gd₂O₃ nanoparticles after the process of pyrolysis.
Figure 12. X-ray diffraction spectrum θ-2θ of a layer of YBa₂Cu₃O₇ with 5% by weight of Gd₂O₃ nanoparticles.
Figure 13. Optical microscopy image of a layer of YBa₂Cu₃O₇ with 5% by weight of Au nanoparticles after the process of pyrolysis.
Figure 14. Scanning electron microscopy image of a layer of YBa₂Cu₃O₇ with 5% by weight of Au nanoparticles.
Figure 15. X-ray diffraction spectrum θ-2θ of a layer of YBa₂Cu₃O₇ with 5% by weight of Au nanoparticles.
Figure 16. Images obtained by atomic force microscopy of atomic forces of auto-assembled (a) nanodots and (b) nanorods of CeO₂ grown on a monocrystalline substrate.
Figure 17. Defects introduced by interfacial nanodots of BaZrO₃ in the YBCO (TEM) matrix.
Figure 18. Critical currents as a function of the magnetic field at 77 K of YBCO grown on auto-assembled nano-templates (red circles). By comparison, the results for a layer of standard YBCO is also shown (blue circles).

### EXAMPLES OF EMBODIMENT OF THE INVENTION

### Example 1

A solution of 50 ml of Y, Ba and Cu trifluoroacetates was prepared with a total metal concentration of 1.5 M (proportions Y:Ba:Cu of 1:2:3). To do this, 8.334 g (0.0125 moles) of commercial YBa₂Cu₃O₇ were weighed in a spherical 250 ml flask connected to a Dimroth refrigerant and provided with magnetic stirring. To this was added 25 ml of recently distilled dry acetone, 22 ml of trifluoracetic anhydride (0.000156 moles) (slow addition to prevent overheating) and 5ml of trifluoracetic acid. The mixture was heated to 50 ºC for 72 hours in an inert atmosphere (Ar). Then, it was cooled to ambient temperature and filtered through a 0.45 µm filter. The resulting solution was evaporated at reduced pressure using a rotary evaporator, first at ambient temperature (2 hours) and later progressively heating to 80 ºC, obtaining the trifluoroacetates of Y, Ba and Cu. One part of the solid obtained was dissolved in acetone and the other in methanol, maintaining both solutions in closed vials in inert atmosphere.

This solution was deposited by the spin coating technique on a monocrystalline SrTiO₃ substrate of dimensions 5 mm * 5 mm, thickness 0.5 mm and orientation (100). Then pyrolysis was performed, consisting of the decomposition of the organic material. To do this, an aluminium crucible was used (where the substrate was placed) that was introduced into a quartz tube of 23 mm diameter, which was placed into an oven. The programme followed by the oven was a heating ramp rate of 300 ºC/h to a maximum temperature of 310 ºC, which was maintained for 30 minutes. A controlled atmosphere was required in the oven, which was a pressure of oxygen of 1 bar, a flow of 0.051 l/min and a water pressure of 24 mbar. This humidity was achieved by passing the gas into wash bottles furnished with a porous plate in the lower internal part to divide the gas into small drops thereby increasing the surface in contact with the water. At the end of the process, the sample was stored in a desiccator.

Starting from the pyrolysed layers, thermal treatment as applied to achieve the formation of the YBa₂Cu₃O₇ phase. The work was done in an oven, where a rapid temperature ramp rise (25 ºC/min) was applied until reaching temperatures in the range of 790-815 ºC. This temperature was maintained for 180 minutes (the last 30 minutes in the dry) and then a steady decrease ramp of 2.5 ºC/min was applied to reach ambient temperature. In this case, 0.2 mbar O₂ and 7 mbar of water pressure was used. The flow of gas was such as allowed by the mass flow meter (using Bronkhorst High-Tech) to achieve a mixture in the range of 0.012 to 0.6 l/min for N₂ and between 0.006 and 0.03 l/min for O₂. Without removing the sample from the oven, it was oxygenated using the same dry atmosphere. The temperature was increased to 450 °C, the gas was changed to dry O₂ at 1 bar pressure and the temperature was maintained for 90 minutes. The temperature was then ramped down at 300 °C/h until it reached ambient temperature. The resulting layer had thickness in the range of approximately 300-800 nm.

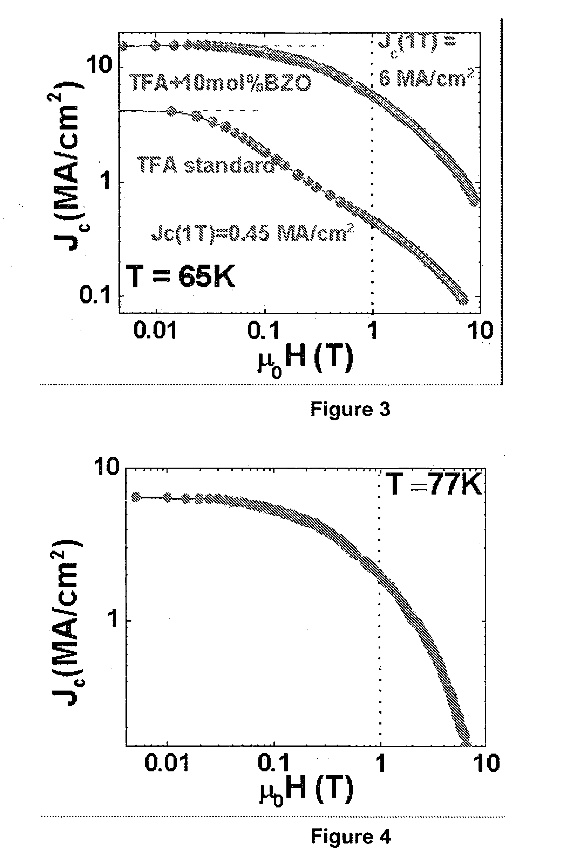

The sample was characterised by X-ray diffraction, SEM imaging and measurements of the critical current at 77 K (J_{c} = 3.5 x 10⁶ A/cm²). For reference values, the dependence of the critical current as a function of the magnetic field applied perpendicularly to the substrate at 65 K (Figure 3) and 77 K (Figure 4) was determined. It was found that at H = 1 T, J_{c} = 0.45 x 10⁶ A/cm² at 65 K. In the absence of the applied field, J_{c} = 4.2 x 10⁶ A/cm² at 65 K.

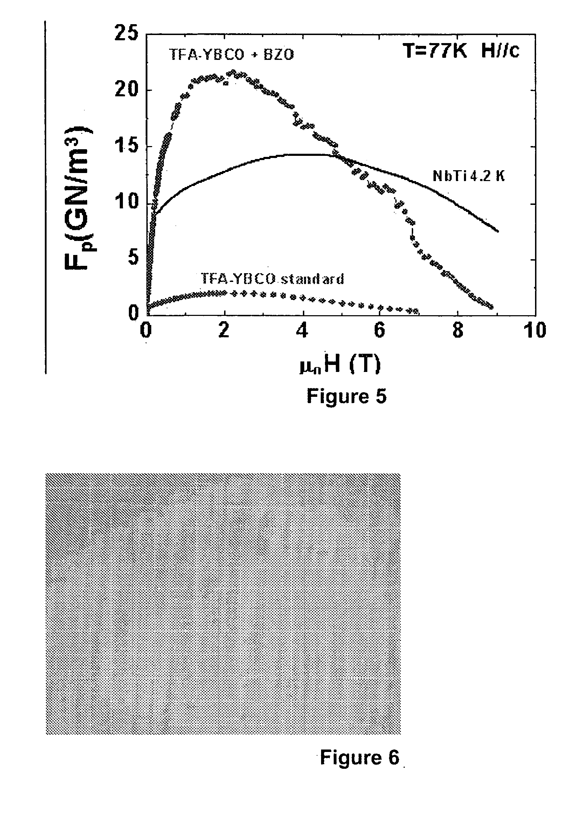

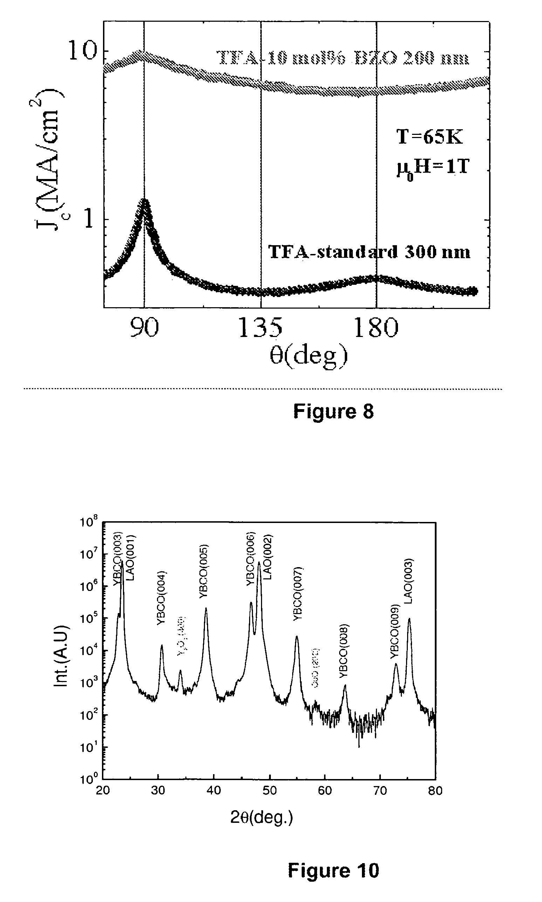

Obtaining these values for the critical current allowed the calculation of the pinning force at 77 K, Fp(B) = J_{c}B (Figure 5). Finally, the anisotropy of the critical current J_{c}(θ) when the magnetic field changed from the H//c orientation to H//ab was determined (Figure 8).

### Example II

In a vial with a septum cap, 21.3 mg of Ba(TFA)₂ (5.9 x 10⁻⁶ moles) and 28.6 mg of Zr(acac)₄ (5.9 x 10⁻⁶ moles) were weighed and 2ml of the methanol solution of YBCO, prepared as in Example I, were added. The mixture was shaken at ambient temperature and filtered through a 0.45 µm filter. The mixture prepared was kept in an atmosphere of Ar.

ICP analysis was performed with the aim to verifying that the initial stoichiometric relationship had been changed, increasing the expected barium and zirconium salt content (5%).

Starting from this solution containing trifluoroacetates or Y, Ba and Cu, containing 5% excess Ba and Zr salts, deposition was performed on a SrTiO₃ substrate under the same conditions as indicated in Example I. The sample deposited was decomposed following the pyrolysis process as described in Example I. The pyrolysed sample was characterised by optical microscopy to verity that it was homogenous and free from cracks and roughness (Figure 6).

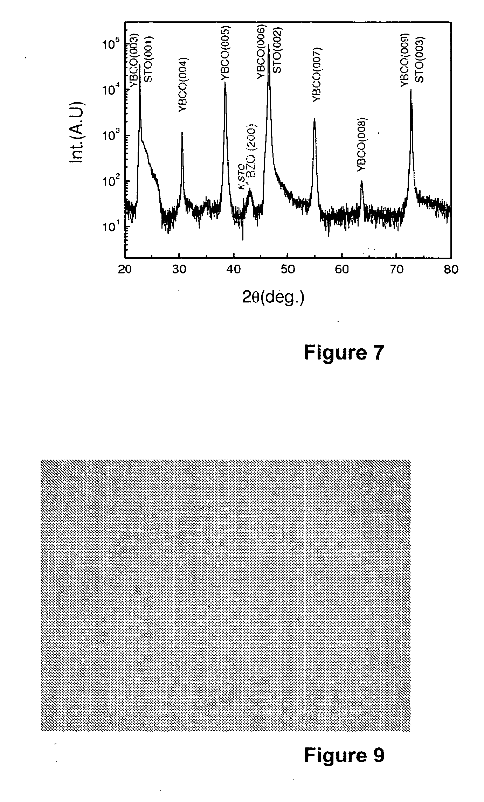

Starting from the pyrolysed sample, thermal treatment was performed as described in Example I to form the YBa₂Cu₃O₇ and BaZrO₃ phases. The resulting layer had thickness in the range of 200-800 nm. The sample was characterised by scanning electron microscopy and by X-ray diffraction (Figure 7) where it was observed that BaZrO₃ nanoparticles were formed. Also, the BaZrO₃ nanoparticles so formed were observed by transmission electron microscopy and the formation of a high density of defects in the YBCO matrix surrounding the nanoparticles (Figure 1 and Figure 2) was observed. In order to study the influence of the BaZrO₃ nanoparticles so formed, and the defects that they cause, the transport critical current of the sample was measured by a standard four-point technique at 65 K (Figure 3) and at 77 K (Figure 4). A value at 77 K of J_{c} = 6.5 x 10⁶ A/cm² in the absence of applied magnetic field was obtained and of J_{c} = 2.2 x 10⁶ A/cm² in a magnetic field of H = 1 T perpendicular to the substrate. At 65 K, a value of J_{c} = 15 x 10⁶ A/cm² was obtained in the absence of a magnetic field and Jc = 6 x 106 A/cm2 in a magnetic field of H = 1 T perpendicular to the substrate. Obtaining these values for the critical current allowed the calculation of the pinning force at 77 K, Fp(B) = J_{c}B and to compare it with the known values in conventional superconducting wires such as NbTi at 4.2 K (Figure 5). As can be observed, the values obtained were very much higher than those currently existing and also improve on low temperature superconductors. Finally, the anisotropy of the critical current J_{c}(θ) when the magnetic field changed from the H//c orientation to H//ab was determined (Figure 8). As can be observed, the behaviour of this value with orientation is rather even. Specifically, the ratio between the maximum and minimum values was approximately 1.5, while in conventional processes it could be 6-7.

### Example III

Starting from the solution of Y, Ba and Cu trifluoroacetates of Example I to which was added 5% by weight of Yttrium trifluoroacetate, a 14µl sample was deposited on a LaAlO₃ substrate (of dimensions 5 mm * 5 mm, thickness 0.5 mm and orientation (100)) by means of the spin-coating technique. The sample deposited was decomposed following the pyrolysis process as described in Example I. The pyrolysed sample was characterised by optical microscopy to check that it was homogenous and free from cracks and roughness (Figure 9).

Starting from the pyrolysed layers, thermal treatment as applied to achieve the formation of the YBa₂Cu₃O₇ and Y₂O₃ phases. The work was done in an oven where a rapid temperature ramp (25 °C/min) was applied until reaching 790-840 °C. This temperature was maintained for 180 minutes (the last 30 minutes in the dry) and then the temperature was ramped down at 2.5 °C/min to ambient temperature. In this case, 0.2 mbar O₂ and 7 mbar of water pressure was used. The flow of gas was such as allowed by the mass flow meter (using Bronkhorst High-Tech) to achieve a mixture in the range of 0.012 to 0.6 l/min for N₂ and between 0.006 and 0.03 l/min for O₂. Without removing the sample from the oven, it was oxygenated using the same dry atmosphere. The temperature was increased to 450 °C, the gas was changed to dry O₂ at 1 bar pressure and the temperature was maintained for 90 minutes. The temperature was then steady ramped down at 300 °C/h until it reached ambient temperature. The resulting layer was approximately 275 nm in thickness.

The sample was characterised by scanning electron microscopy and by X-ray diffraction (Figure 10) where it was observed that Y₂O₃ nanoparticles were formed.

### Example IV

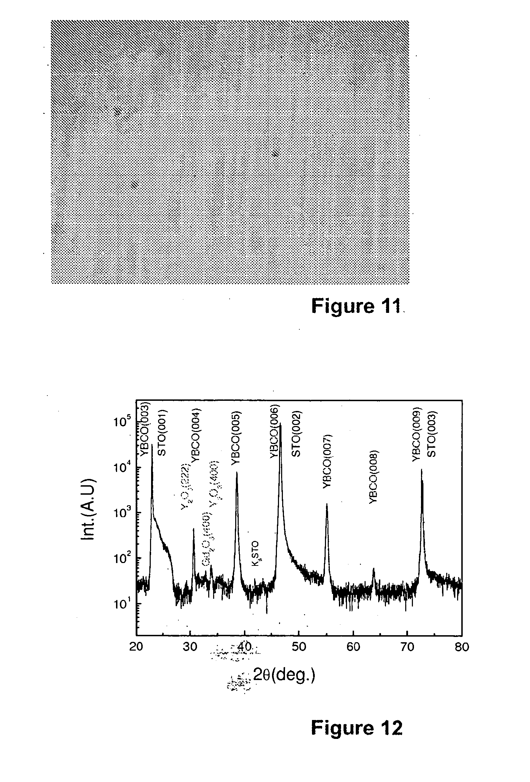

Starting from the solution of Y, Ba and Cu trifluoroacetates of Example I to which was added 5% by weight of Gadolinium acetylacetonate, a 14µl sample was deposited on a SrTiO₃ substrate (of dimensions 5 mm * 5 mm, thickness 0.5 mm and orientation (100)) by means of the spin-coating technique. The sample deposited was decomposed following the pyrolysis process as described in Example I. The pyrolysed sample was characterised by optical microscopy to check that it was homogenous and free from cracks and roughness (Figure 11).

Starting from the pyrolysed sample, thermal treatment was performed as described in Example I to form the YBa₂Cu₃O₇ and Gd₂O₃ phases. The resulting layer had thickness in the range of 300-800 nm. The sample was characterised by scanning electron microscopy and by X-ray diffraction (Figure 12) where it was observed that Gd₂O₃ nanoparticles were formed. Measurements of the critical currents confirmed that their dependence with the magnetic field was smoother in the nano-composite material.

### Example V

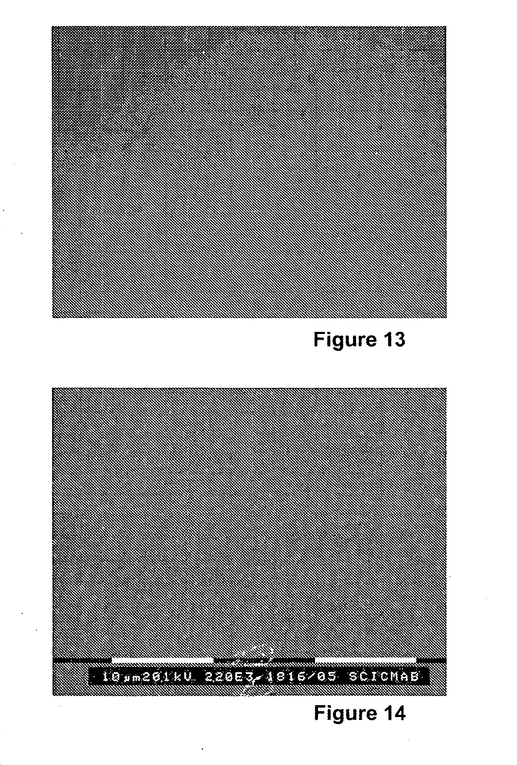

Starting from the solution of Y, Ba and Cu trifluoroacetates of Example I to which was added 5% by weight of HAuCl₄, a 14µl sample was deposited on a LaAlO₃ substrate (of dimensions 5 mm * 5 mm, thickness 0.5 mm and orientation (100)) by means of the spin-coating technique. The sample deposited was decomposed following the pyrolysis process as described in Example I. The pyrolysed sample was characterised by optical microscopy to check that it was homogenous and free from cracks and roughness (Figure 13).

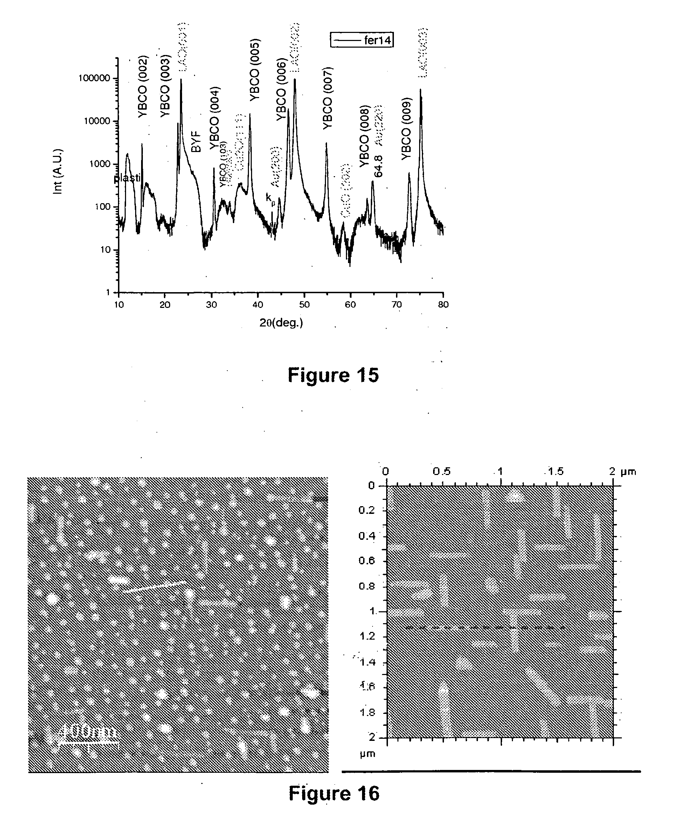

Starting from the pyrolysed sample, thermal treatment was performed as described in Example III to form the YBa₂Cu₃O₇ and Au phases. The sample was characterised by scanning electron microscopy (Figure 14) and by X-ray diffraction (Figure 15) where it was observed that Au nanoparticles were formed. The resulting layer had thickness in the range of 300-800 nm.

### Example VI

A solution of Ce and Gd propionates in isopropanol was prepared, with molar proportions of between 0 and 15% Gd, at concentrations of between 0.02 M and 0.003 M. A sample of 14µl was deposited on substrates of SrTiO₃ and LaAlO₃ (orientation (100)) by means of spin-coating. Also, a solution of Ba acetate and Zr acetylacetonate was prepared in stoichiometric molar proportions of 1:1. The deposited samples were decomposed using a pyrolysis process followed by a process of growth at high temperatures (900-1000 °C) with variable durations (5-30 minutes). The atmosphere during the growth was O₂ or a mixture of Ar-5% H₂ and the ramp rise of temperature was fixed at °C/h. The morphology and size of the auto-assembled nanostructures that resulted were controlled by means of atomic force microscopy and some typical examples are shown in Figure 16. In these figures the nanometric dimensions of the generated structures of the Ce₁₋ₓGdₓO₂ oxide can be observed as well as significant changes in their morphology (nanodots and nanorods). These substrates constitute excellent templates for the deposition of superconducting films with improved properties.

### Example VII

Starting from the solution of Example I of Y, Ba and Cu trifluoroacetates, a 14µl sample was deposited on LaAlO3 and SrTi03 substrates with auto-assembled nanostructures obtained according to Example VI (of dimensions 5 mm * 5 mm, thickness 0.5 mm and orientation (100)) by means of the spin-coating technique. The sample deposited was decomposed following the pyrolysis process as described in Example I. The pyrolysed sample was characterised by optical microscopy to check that it was homogenous and free from cracks and roughness. Starting from the pyrolysed layers, thermal treatment as applied to achieve the formation of the YBa₂Cu₃O₇ phase. The work was done in an oven where a rapid ramp rise in temperature (25 °C/min) was applied until reaching 790-840 °C. This temperature was maintained for 180 minutes (the last 30 minutes in the dry) and then the sample was progressively cooled at 2.5 °C/min to ambient temperature. In this case, 0.2 mbar O₂ and 7 mbar of water pressure was used. The flow of gas was such as allowed by the mass flow meter (using Bronkhorst High-Tech) to achieve a mixture in the range of 0.012 to 0.6 l/min for N₂ and between 0.006 and 0.03 l/min for O₂. Without removing the sample from the oven, it was oxygenated using the same dry atmosphere. The temperature was increased to 450 °C, the gas was changed to dry O₂ at 1 bar pressure and the temperature was maintained for 90 minutes. The temperature was then ramped down at 300 °C/h until it reached ambient temperature. The resulting layer was approximately 200-300 nm in thickness.

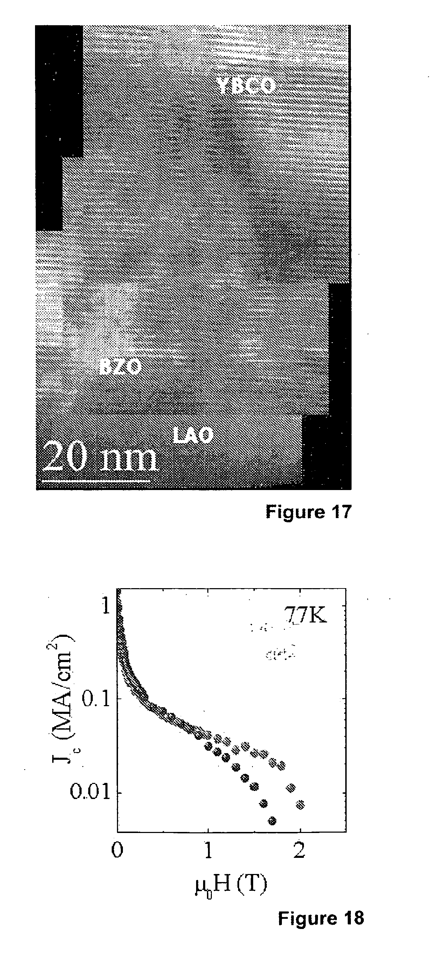

The sample was characterised by scanning electron microscopy, by X-ray diffraction, by transmission electron microscopy and the critical currents were measured by inductive or transport techniques. Figure 17 is a typical TEM image showing that a BaZrO₃ nanoparticle introduced defects into the REBa₂Cu₃O₇ matrix. Figure 18 shows the dependency of the critical currents with the magnetic field at 77 K in two samples, one grown on a nanostructured sample and the other on a normal sample. As can be observed, there was in increase in the critical current at high magnetic field due to the defects introduced into the REBa₂Cu₃O₇ matrix.

## Claims

1. Nanostructured superconducting material of the type REBa₂Cu₃O₇, where RE=Rare Earth or Yttrium **characterised by** a structure comprising:
two phases:
o a main matrix of REBa₂Cu₃O₇,
o a secondary phase of BaZrO₃ distributed at random throughout the matrix,
and with a density of nanometric defects in its structure in the range of 10³-10⁴ defects/µm³.

2. System formed by the superconducting material described in claim 1 and a substrate on which the material has been deposited.

3. System of claim 2 **characterised in that** the substrate used is a rigid monocrystalline film.

4. System of claim 2 **characterised in that** the substrate used is a flexible metal tape.

5. Procedure for obtaining the nanostructured superconducting material described in claims 1-4 comprising the stages of:
a) preparation of a precursor trifluoroacetate solution with various salts of Zr,
b) deposition of the solution on a substrate by means of any method enabling the homogenous control of the thickness of the film,
c) decomposition of the metal-organic precursors by means of thermal treatment in a controlled atmosphere,
d) thermal treatment at high temperature in a controlled atmosphere to crystallise the superconducting layer,
**characterised in that** the precursor solution of stage a) contains variable proportions of the salts of alkaline metals, alkaline earth metals, rare earth metals and/or transition metals.

6. Procedure of claim 5 **characterised in that** the salts of alkaline metals, alkaline earth metals, rare earth metals and/or transition metals used in stage a) are organic salts such as acetates, trifluoroacetates, acetylacetonates, ethylhexanoates or propionates, soluble in the reaction medium to prevent the formation of precipitates.

7. Procedure of claim 5 **characterised in that** complex anhydride solutions of RE, Ba and Cu trifluoroacetates are obtained in stage a).

8. Procedure of claim 5 **characterised in that** any anhydride corresponding to an organic acid that dissolves oxide powders is used in stage a).

9. Procedure of claim 7 in which trifluoroacetic anhydride (CF₃CO)₂O) and a small quantity of trifluoracetic acid (CF₃COOH) (5% by volume) as catalyst of the reaction is used in stage a).

10. Procedure of claim 5 in which solutions of metal trifluoroacetates are used in stage a) with variable proportions of metal or metal oxide nanoparticles, where these nanoparticles have been prepared by oxidation-reduction reactions, precipitation and stabilisation using surfactants, polymers or organic species able to link to their surface thereby preventing their aggregation.

11. Procedure of claims 5-10 in which the substrate used in stage b) has previously been covered with a layer of BaZrO₃ nanoparticles by means of auto-assembly processes based on growth from metal-organic solutions or in the deposition of previously synthesised nanoparticles.

12. Use of the nanostructured superconducting material described in claims 1-4 in electronic or electric systems..

## Patentansprüche

1. Nanostrukturiertes supraleitendes Material des Typs REBa₂Cu₃O₇, worin RE = seltene Erde oder Yttrium ist, **gekennzeichnet durch** eine Struktur, die zwei Phasen:
• eine Hauptmatrix aus REBa₂Cu₃O₇,
• eine sekundäre Phase aus BaZrO₃, die in der Matrix zufällig verteilt ist, umfasst,
mit einer Dichte nanometergroßer Defekte in dessen Struktur im Bereich von 10³ bis 10⁴ Defekten/µm³.

2. System bestehend aus dem supraleitenden Material nach Anspruch 1 und einem Substrat, auf dem das Material abgelagert wurde.

3. System nach Anspruch 2, **dadurch gekennzeichnet, dass** das verwendete Substrat ein unbiegsamer monokristalliner Film ist.

4. System nach Anspruch 2, **dadurch gekennzeichnet, dass** das verwendete Substrat ein biegsames Metallband ist.

5. Verfahren zur Herstellung des nanostrukturierten supraleitenden Materials nach den Ansprüchen 1 bis 4, das folgende Stufen umfasst:
a) Herstellung einer Vorläufer-Trifluoracetatlösung mit verschiedenen Zr-Salzen,
b) Ablagerung der Lösung auf einem Substrat mittels einer Methode, die eine homogene Kontrolle der Filmdicke erlaubt,
c) Zersetzung der metallorganischen Vorläufer durch Wärmebehandlung in einer kontrollierten Atmosphäre,
d) Wärmebehandlung bei hoher Temperatur in einer kontrollierten Atmosphäre zur Kristallisierung der supraleitenden Schicht,
**dadurch gekennzeichnet, dass** die Vorläuferlösung aus Stufe a) unterschiedliche Anteile an Alkalimetall-, Erdalkalimetall-, seltenen Erden-Metall- und/oder Übergangsmetall-Salzen enthält.

6. Verfahren nach Anspruch 5, **dadurch gekennzeichnet, dass** die in Stufe a) eingesetzten Alkalimetall-, Erdalkalimetall-, seltenen Erden-Metall- und/oder Übergangsmetall-Salze organische Salze wie Acetate, Trifluoracetate, Acetylacetonate, Ethylhexanoate oder Propionate sind, die im Reaktionsmedium löslich sind, um die Bildung von Niederschlägen zu vermeiden.

7. Verfahren nach Anspruch 5, **dadurch gekennzeichnet, dass** in Stufe a) komplexe Anhydridlösungen von RE-, Ba- und Cu-Trifluoracetaten erhalten werden.

8. Verfahren nach Anspruch 5, **dadurch gekennzeichnet, dass** in Stufe a) ein einer organischen Säure entsprechendes Anhydrid, das Oxidpulver löst, eingesetzt wird.

9. Verfahren nach Anspruch 7, wobei in Stufe a) Trifluoracetanhydrid (CF₃CO)₂O) und eine kleine Menge Trifluoressigsäure (CF₃COOH) (5 Vol.-%) als Katalysator der Reaktion eingesetzt wird.

10. Verfahren nach Anspruch 5, worin in Stufe a) Lösungen von Metalltrifluoracetaten mit unterschiedlichen Anteilen an Metall- oder Metalloxid-Nanopartikeln eingesetzt werden, wobei diese Nanopartikel über Oxidations-und Reduktions-Reaktionen, Fällung und Stabilisierung unter Verwendung von Tensiden, Polymeren oder organischen Spezies hergestellt wurden, die in der Lage sind, an deren Oberfläche zu binden, um so ihre Aggregation zu verhindern.

11. Verfahren nach den Ansprüchen 5 bis 10, worin das in Stufe b) eingesetzte Substrat vorher mit einer Schicht BaZrO₃-Nanopartikel durch Selbstassemblierungsprozesse basierend auf Wachstum aus metallorganischen Lösungen oder Ablagerung von zuvor synthetisierten Nanopartikeln beschichtet wurde.

12. Verwendung des nanostrukturierten supraleitenden Materials nach den Ansprüchen 1 bis 4 in elektronischen oder elektrischen Systemen.

## Revendications

1. Matériau nanostructuré supraconducteur du type REBa₂Cu₃O₇, où RE = Terre Rare ou Yttrium **caractérisé par** une structure comprenant : deux phases :
○ une matrice principale de REBa₂Cu₃O₇,
○ une phase secondaire de BaZrO₃ distribuée au hasard dans toute la matrice,
et dont la structure a une densité de défauts nanométriques de l'ordre de 10³-10⁴ défauts/µm³.

2. Système formé par le matériau supraconducteur décrit dans la revendication 1 et un substrat sur lequel le matériau a été déposé.

3. Système de la revendication 2 **caractérisé en ce que** le substrat utilisé est un film microcristallin rigide.

4. Système de la revendication 2 **caractérisé en ce que** le substrat utilisé est une bande en métal souple.

5. Procédure pour obtenir le matériau nanostructuré supraconducteur décrit dans les revendications 1-4 comprenant les étapes de :
a) préparation d'une solution de trifluoroacétate précurseur avec divers sels de Zr,
b) dépôt de la solution sur un substrat au moyen de tout procédé permettant le contrôle homogène de l'épaisseur du film,
c) décomposition des précurseurs organométalliques par traitement thermique dans une atmosphère contrôlée,
d) traitement thermique à haute température dans une atmosphère contrôlée pour cristalliser la couche supraconductrice,
**caractérisée en ce que** la solution précurseur de l'étape a) contient des proportions variables des sels de métaux alcalins, métaux alcalino-terreux, métaux de terres rares et/ou métaux de transition.

6. Procédure de la revendication 5 **caractérisée en ce que** les sels de métaux alcalins, métaux alcalino-terreux, métaux de terres rares et/ou métaux de transition utilisés dans l'étape a) sont des sels organiques tels que des acétates, trifluoroacétates, acéthylacétonates, éthylhexanoates ou propionates, solubles dans le milieu réactionnel pour empêcher la formation de précipités.

7. Procédure de la revendication 5 **caractérisée en ce que** des solutions anhydrides complexes de trifluoroacétates de RE, Ba et Cu sont obtenues dans l'étape a).

8. Procédure de la revendication 5 **caractérisée en ce que** n'importe quel anhydride correspondant à un acide organique qui dissout des poudres d'oxyde est utilisé dans l'étape a).

9. Procédure de la revendication 7 dans laquelle on utilise dans l'étape a) de l'anhydride trifluoroacétique (CF₃CO)₂O) et une petite quantité d'acide trifluoroacétique (CF₃COOH) (5% de volume) comme catalyseur de la réaction.

10. Procédure de la revendication 5 dans laquelle des solutions de trifluoroacétates de métal sont utilisées dans l'étape a) avec des proportions variables de nanoparticules de métal ou d'oxydes métalliques, où ces nanoparticules ont été préparées par des réactions d'oxydation-réduction, précipitation et stabilisation en utilisant des agents tensio-actifs, polymères ou espèces organiques capables de se lier à leur surface empêchant ainsi leur agrégation.

11. Procédure des revendications 5-10 dans laquelle le substrat utilisé dans l'étape b) a préalablement été recouvert d'une couche de nanoparticules de BaZrO₃ par des procédés d'auto-assemblage basés sur la croissance à partir de solutions organométalliques ou sur le dépôt de nanoparticules préalablement synthétisées.

12. Utilisation du matériau nanostructuré supraconducteur décrit dans les revendications 1-4 dans des systèmes électroniques ou électriques.
